# EUROPEAN PATENT APPLICATION

(11) **EP 2 381 456 A2**
(43) Date of publication of application: **26.10.2011**
(21) Application number: 11159932.0
(22) Date of filing: 28.03.2011
(51) Int. Cl.: H01H 13/48, H03K 17/98

(54) **Method and apparatus for performing a function**

(30) Priority: 01.04.2010 US 752818
(71) Applicant: Nokia Corporation, 02150 Espoo (FI)
(72) Inventor: Mäenpää, Jani, 00230 Espoo (FI); Dimaras, Dimitrios, Espoo (FI)
(74) Representative: Khan, Mohammed Saiful Azam

(57) **Abstract**

In accordance with an example embodiment of the present invention, an apparatus comprises an element having at least one elongated member, the at least one elongated member having at least one conductive end and being extendable from a retracted position to at least one extended position; a component coupled with said element, the component having at least one conductive surface at least partially opposing a side of said at least one conductive end when said at least one elongated member is in said at least one extended position; and a dielectric disposed on at least one of said at least one conductive end and said at least one conductive surface.

## Description

### TECHNICAL FIELD

The present application relates generally to a method and apparatus for performing a function.

### BACKGROUND

Electronic devices may include various user interface components and methods for enabling users to perform functions such as controlling a display, moving a cursor, entering data and/or the like. Some user interface components and methods may be more effective and efficient for enabling users to perform certain functions than others. For example, some users may agree that performing a function such as moving a cursor on a display may be easier with a navigation key rather than a conventional computer keyboard.

### SUMMARY

Various aspects of examples of the invention are set out in the claims. According to a first aspect of the present invention, an apparatus comprises an element having at least one elongated member, the at least one elongated member having at least one conductive end and being extendable from a retracted position to at least one extended position; a component coupled with the element, the component having at least one conductive surface at least partially opposing a side of the at least one conductive end when the at least one elongated member is in the at least one extended position; and a dielectric disposed on at least one of the at least one conductive end and the at least one conductive surface.

According to a second aspect of the present invention, a method comprises applying voltage between at least one conductive end of an element having at least one elongated member and at least one conductive surface of a component; moving the at least one conductive end by extending the at least one elongated member from a retracted position to at least one extended position such that a side of the at least one conductive end at least partially opposes at least one conductive surface; and measuring at least one capacitance level between the at least one conductive end and the at least one conductive surface.

According to a third aspect of the present invention, an apparatus comprises at least one processor; and at least one memory comprising computer program code, the at least one memory and the computer program code configured to, with the at least one processor, cause the apparatus to perform at least the following: apply a voltage between at least one conductive end of an element having at least one elongated member and at least one conductive surface of a component; and detect a change in at least one capacitance level between the at least one conductive end and the at least one conductive surface in response to a movement of the at least one conductive end of the element between a retracted position and at least one extended position.

### BRIEF DESCRIPTION OF THE DRAWINGS

For a more complete understanding of example embodiments of the present invention, reference is now made to the following descriptions taken in connection with the accompanying drawings in which:

Figure 1 is a diagram of an apparatus shown in an assembled configuration according to an example embodiment of the invention;

Figure 2a is a diagram of an exploded view of the apparatus in Figure 1 according to an example embodiment of the invention;

Figure 2b is a diagram of a component having eight conductive surfaces according to an example embodiment of the invention;

Figure 2c is a diagram of a another component having eight conductive surfaces according to an example embodiment of the invention;

Figure 2d is a diagram of an element having eight elongated members according to an example embodiment of the invention;

Figure 2e is a diagram of a shield according to an example embodiment of the invention;

Figure 2f is a diagram of an element actuator according to an example embodiment of the invention;

Figure 2g is a diagram of a dome switch according to an example embodiment of the invention;

Figure 2h is a diagram of a dome actuator according to an example embodiment of the invention;

Figure 3 is diagram of a cross sectional view along line 1a-1b of apparatus 100 of Figure 1 according to an example embodiment of the invention;

Figure 4 is a representation of movement of an elongated member of an element according to an embodiment of an invention;

Figure 5 is a diagram of an electronic device according to an example embodiment of the invention;

Figure 6 is a block diagram of an electronic device of Figure 5 according to an example embodiment of the invention; and

Figure 7 is a flow diagram illustrating an example method for performing a function according to an example embodiment of the invention.

### DETAILED DESCRIPTON OF THE DRAWINGS

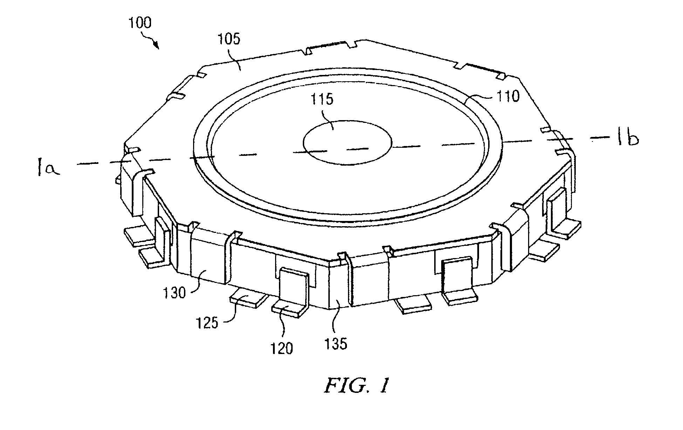

An example embodiment of the present invention and its potential advantages are understood by referring to Figures 1 through 7 of the drawings.

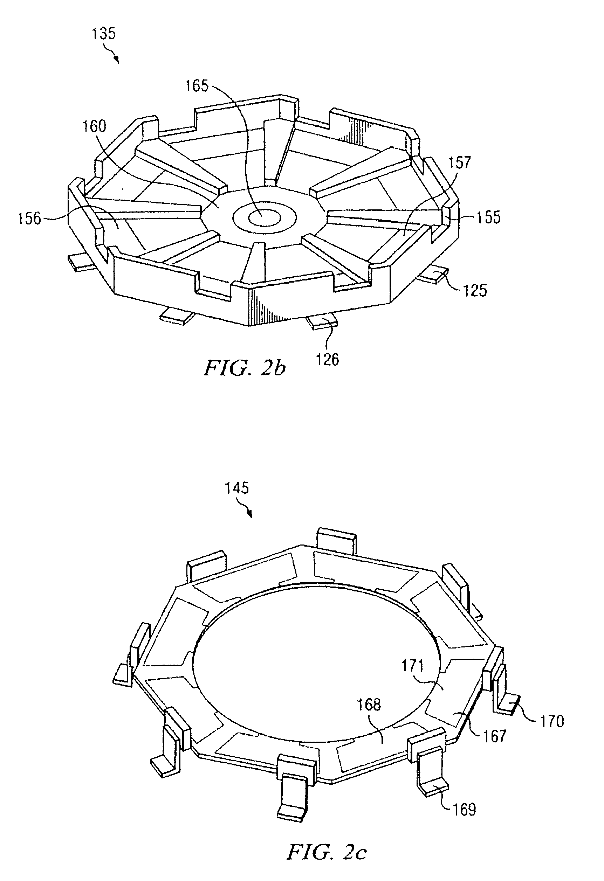

Figure 1 is a diagram of an apparatus 100 shown in an assembled configuration according to an example embodiment of the invention. In an embodiment, apparatus 100 comprises a shield 105, element actuator 110, a component 135 and a center actuator 115 each coupled with apparatus 100. In an embodiment, component 135 comprises at least one external contact point 125 coupled with at least one conductive surface 155 of Figure 2b.

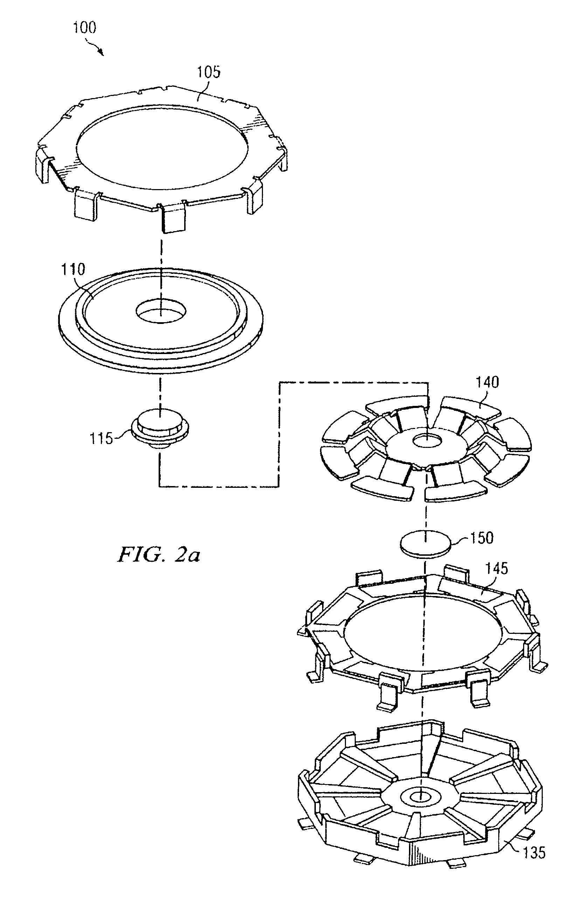

Figure 2a is a diagram of an exploded view of apparatus 100 of Figure 1 according to an example embodiment of the invention. According to Figure 2a, apparatus 100 comprises a shield 105, element actuator 110, center actuator 115, element 140, dome switch 150, component 145 and component 135 each coupled with apparatus 100.

Figure 2b is a diagram of a component 135 comprising eight conductive surfaces according to an example embodiment of the invention. In an embodiment, component 135 comprises at least one conductive surface such as conductive surface 155 and 156. In an embodiment, component 135 comprises at least one external contact point such as external contact points 125 and 126. In an embodiment, component 135 comprises at least one center actuator contact point such as center actuator inner contact point 165 and a center actuator outer contact point 160. Further, in an embodiment, a dielectric such as dielectric 157 is disposed on a top side of at least one conductive surface such as conductive surface 155 and 156. In an embodiment, component 135 is component 135 of Figure 2a.

Figure 2c is a diagram of a another component such as component 145 comprising eight conductive surfaces according to an example embodiment of the invention. In an embodiment, component 145 comprises at least one conductive surface on a bottom side of component 145 such as conductive surfaces 167 and 168. In an embodiment, component 145 comprises at least one external contact point such as external contact point 170 coupled with conductive surface 167 and external contact point 169 coupled with conductive surface 168. Further, in an embodiment, a dielectric such as dielectric 171 is disposed on a bottom side of at least one conductive surface such as conductive surface 167 and 168. In an embodiment, component 145 is component 145 of Figure 2a.

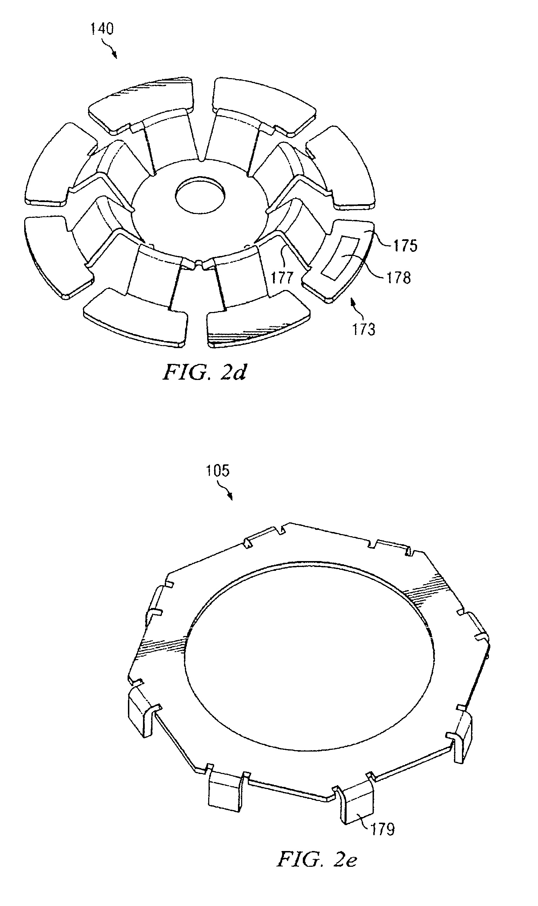

Figure 2d is a diagram of an element 140 having eight elongated members according to an example embodiment of the invention. In an embodiment, an element such as element 140 comprises at least one elongated member such as elongated member 173. In an embodiment, an elongated member such as elongated member 173 comprises a conductive end such as conductive end 175 and a resilient member such as resilient member 177. In an embodiment, resilient member 177 is a spring. Further, in an embodiment, a dielectric such as dielectric 178 is disposed on at least one of a bottom side and a top side of at least one conductive end such as conductive end 175. In an embodiment, element 140 is element 140 of Figure 2a.

Figure 2e is a diagram of a shield such as shield 105 according to an example embodiment of the invention. In an embodiment, a shield 105 comprises at least one connector such as connector 179 capable of coupling the shield with a component such as component 135 of Figure 2b. In an embodiment, shield 105 is shield 105 of Figure 2a.

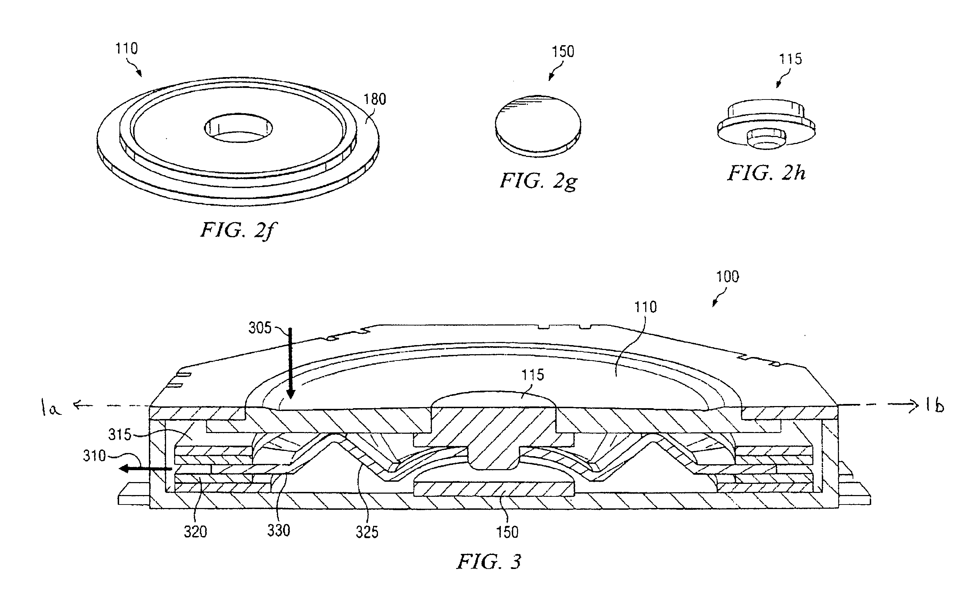

Figure 2f is a diagram of an element actuator such as element actuator 110 according to an example embodiment of the invention. In an embodiment, element actuator 110 has an opening such as opening 180 capable of receiving a center actuator such as center actuator 115 of Figure 2h. In an embodiment, element actuator 110 is element actuator 110 of Figure 2a.

Figure 2g is a diagram of a dome switch such as dome switch 150 according to an example embodiment of the invention. In an embodiment, a dome switch is capable of making contact with inner and outer contact points 165 and 160 of Figure 2b when actuated. In an embodiment, dome switch 150 is dome switch 150 of Figure 2a.

Figure 2h is a diagram of a dome actuator such as dome actuator 115 according to an example embodiment of the invention. In an embodiment, a dome actuator is capable of making contact and actuating a dome switch such as dome switch 150 of Figure 2g. In an embodiment, dome actuator 115 is dome actuator 115 of Figure 2a.

Figure 3 is diagram of a cross sectional view along line 1a-1b of apparatus 100 of Figure 1 according to an example embodiment of the invention. In an embodiment, a user such as a user of an electronic device comprising an apparatus such as apparatus 100 presses an element actuator such as element actuator 110. A user may press an element actuator in a particular area of the element actuator to perform a function with an electronic device such as at least one of controlling a display, moving a cursor, entering data, actuating a switch and the like. In an embodiment, when a user presses element actuator 110 in a particular area of the element actuator such as the area indicated by arrow 305, a force is exerted on at least one elongated member of an element such as elongated member 325. In an embodiment, when a force is exerted on at least one elongated member such as elongated member 325, the force may cause elongated member 325 to extend in a direction such as in the direction of arrow 310 such that a conductive end of elongated member 325 at least partially opposes at least one of conductive surface 320 of a component and conductive surface 315 of a component.

In an embodiment, an element including at least one elongated member such as elongated member 325 comprised therein is connected with electric ground or a voltage of 0 (zero). Further, in an embodiment, at least one of a conductive surface of a component such as conductive surface 320 and a conductive surface of a component such as conductive surface 315 is held at a particular voltage such as five volts. Further, in an embodiment, a dielectric may be disposed on at least one of a conductive surface of a component, a conductive surface of a component, a top surface of a conductive end and a bottom surface of a conductive end.

In an embodiment, when an elongated member such as elongated member 325 extends in a direction such as in the direction of arrow 310 as a result of a user actuating an element actuator such as element actuator 110, a capacitance may form between a surface of a conductive end of an elongated member and at least one of a conductive surface 320 of a component and a conductive surface 315 of a component. In an embodiment, as elongated member 325 increasingly extends toward the direction of arrow 310, at least one surface of conductive end 330 will increasingly oppose at least one of conductive surface 320 and conductive surface 315 thereby increasing a capacitance level between at least one surface of conductive end 330 and at least one of conductive surface 320 and conductive surface 315.

In an embodiment, as elongated member 325 retracts in the opposite direction of arrow 310, conductive end 330 will decreasingly oppose at least one of conductive surface 320 and conductive surface 315 thereby decreasing a capacitance level between at least one surface of conductive end 330 and at least one of conductive surface 320 and conductive surface 315. In an embodiment, a capacitance between at least one conduct surface of conductive end 330 and at least one of conductive surface 320 and conductive surface 315 is detected and based on at least one of a capacitance level, a capacitance increase and a capacitance decrease, at least one function is performed on an electronic device.

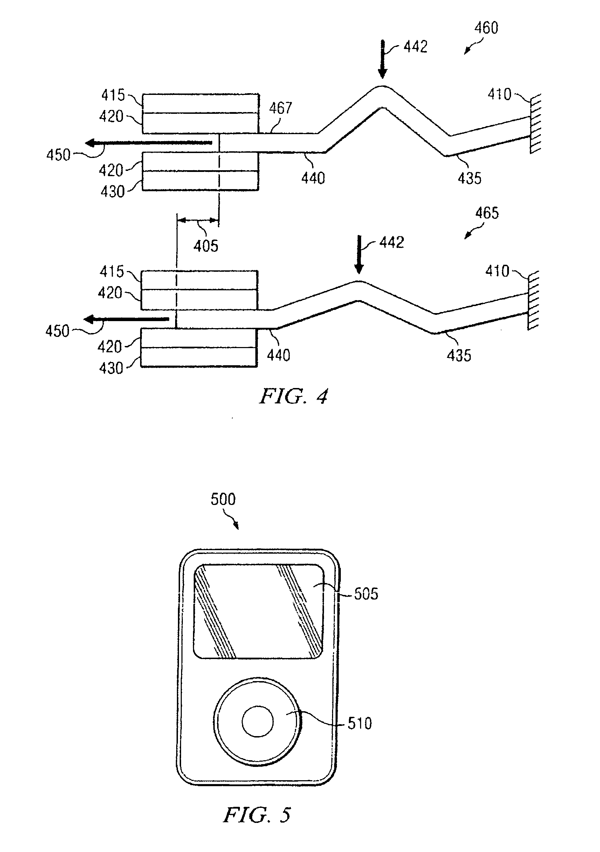

In an embodiment, a user presses dome actuator 115 to perform a function. In an embodiment, the function includes any function such as entering data, controlling an electronic device and/or the like. In an embodiment, when a user presses dome actuator 115 with sufficient force to perform a function, dome actuator 115 actuates dome switch 150. In an embodiment, actuating dome switch 150 sends a signal to an electronic device such as electronic device 500 of Figure 5 to perform a function.

Figure 4 is a representation of movement of an elongated member such as elongated member 435 of an element according to an embodiment of an invention. In an embodiment, an elongated member 435 is connected with electric ground or a voltage of zero at 410. Further, in an embodiment, at least one conductive surface 430 of a component and a conductive surface 415 of a component is held at a particular voltage, for example, five volts. Further, in an embodiment, a dielectric 420 is disposed on at least one of conductive surface 430 of a component, conductive surface 415 of a component, a top surface of conductive end 440 and bottom surface of a conductive end 440.

In an embodiment, when an elongated member such as elongated member 435 extends in a direction such as the direction of arrow 450 as a result of a force 442 exerted on elongated member 435, a capacitance may form between conductive end 440 of an elongated member and at least one of a conductive surface of a component 430 and a conductive surface 415 of a component. In an embodiment, as an elongated member 435 increasingly extends toward the direction of arrow 445, surfaces of conductive end 440 will increasingly oppose conductive surface 415 and conductive surface 430 thereby increasing a capacitance level between a surface of conductive end 440 and at least one of conductive surface 415 and conductive surface 430. In an embodiment, as elongated member 435 retracts in the opposite direction of arrow 450, surfaces of conductive end 440 will decreasingly oppose conductive surface 415 and conductive surface 430 thereby decreasing a capacitance level between at least one surface of conductive end 440 and at least one of conductive surface 415 and conductive surface 430. In an embodiment, a capacitance between at least one surface of conductive end 440 and at least one of conductive surface 415 and conductive surface 430 is detected and based on at least one of a capacitance level, a capacitance increase and a capacitance decrease, at least one function may performed on an electronic device.

Figure 5 is a diagram of an electronic device 500 according to an example embodiment of the invention. In an embodiment, electronic device 500 comprises an apparatus such as apparatus 100 of Figure 1 and a display 505. An electronic device may be any type of electronic device including but not limited to at least one of a camera, video camera, communication device, phone, media player, global positioning device and/or the like.

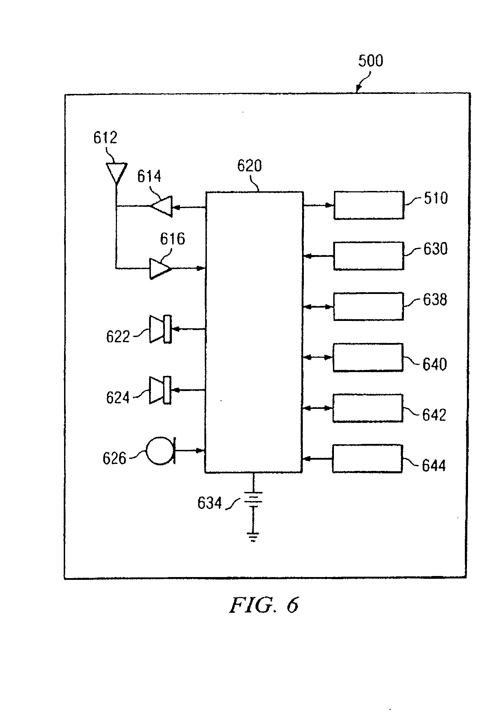

Figure 6 is a block diagram of electronic device 500 of Figure 5 according to an example embodiment of the invention. In an embodiment, electronic device 500 comprises at least one antenna 612 in communication with a transmitter 614 and a receiver 616. In an embodiment, electronic device 500 further comprises at least one processor such as processor 620. In an embodiment, electronic device 500 further comprises one or more other processing components. In an embodiment, processor 620 provides at least one signal to the transmitter 614 and receives at least one signal from the receiver 616. Further, in an embodiment, electronic device 500 comprises user interface elements that include at least one input element and/or output elements, such as but not limited to an earphone or speaker 624, a ringer 622, a microphone 626, a keypad 638, a display 630 and/or the like. In an embodiment, display 630 is at least one of a touch screen, liquid crystal display, and the like capable of displaying text and graphical information. In an embodiment, user interface elements are coupled with processor 620. In an embodiment, the electronic device 500 further comprises a GPS receiver 640 capable of determining the location of electronic device 500. In an embodiment, the electronic device 500 further comprises a battery 634, such as a vibrating battery pack for powering various circuits to operate electronic device 500. In an embodiment, electronic device 500 further comprises a volatile memory 642 and a non-volatile memory 644 coupled with processor 620.

In an embodiment, electronic device 500 further comprises an apparatus such as apparatus 510 coupled with electronic device 500. In an embodiment, apparatus 510 is apparatus 510 of Figure 5. In an embodiment, apparatus 510 is apparatus 100 of Figure 1.

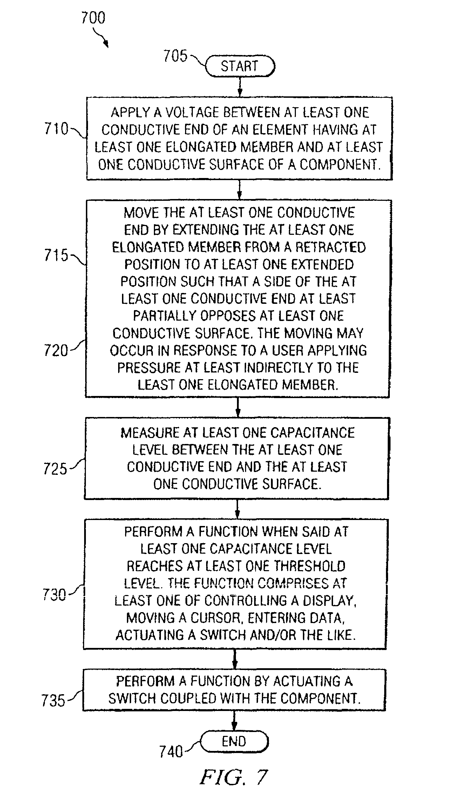

Figure 7 is a flow diagram illustrating an example method 700 for performing a function according to an example embodiment of the invention. At 705, the method begins. In an embodiment at 710, a voltage is applied between at least one conductive end such as conductive end 175 of Figure 2d of an element and at least one conductive surface such as conductive surface 155 of Figure 2d of a component. In an embodiment, an element such as element 140 of Figure 2d has at least one elongated member such as elongated member 177 of Figure 2d.

In an embodiment at 715, at least one conductive end is moved by extending at least one elongated member from a retracted position such as retracted position 460 of Figure 4 to at least one extended position such as extended position 465 such that a side such as side 467 of Figure 4 of the at least one conductive end at least partially opposes at least one conductive surface such as conductive surface 415 of Figure 4. In an embodiment, the moving occurs in response to a user applying pressure at least indirectly to the at least one elongated member.

In an embodiment at 725, at least one capacitance level is measured between the at least one conductive end and the at least one conductive surface.

In an embodiment at 730, a function is performed when at least one of the capacitance level reaches at least one threshold level, capacitance level increases and capacitance level decreases. In an embodiment, a function comprises at least one of controlling a display, moving a cursor, entering data, actuating a switch and the like.

In an embodiment at 735, a function is performed when a switch such as dome switch 115 of Figure 3 is actuated by a user of an apparatus. At 740, the method ends.

Without in any way limiting the scope, interpretation, or application of the claims appearing below, a technical effect of one or more of the example embodiments disclosed herein is to provide an apparatus such that actuating an element actuator produces a capacitance that is proportional to the degree of actuation. Another technical effect of one or more of the example embodiments disclosed herein is to provide an element actuator and a dome actuator in a single apparatus.

Embodiments of the present invention may be implemented in software, hardware, application logic or a combination of software, hardware and application logic. The software, application logic and/or hardware may reside on an electronic device such as but not limited to a communication device. In an example embodiment, the application logic, software or an instruction set is maintained on any one of various conventional computer-readable media. In the context of this document, a "computer-readable medium" may be any media or means that can contain, store, communicate, propagate or transport the instructions for use by or in connection with an instruction execution system, apparatus, or device, such as a computer, with one example of a computer described and depicted in Figure 6. A computer-readable medium may comprise a computer-readable storage medium that may be any media or means that can contain or store the instructions for use by or in connection with an instruction execution system, apparatus, or device, such as a computer.

If desired, the different functions discussed herein may be performed in a different order and/or concurrently with each other. Furthermore, if desired, one or more of the above-described functions may be optional or may be combined.

Although various aspects of the invention are set out in the independent claims, other aspects of the invention comprise other combinations of features from the described embodiments and/or the dependent claims with the features of the independent claims, and not solely the combinations explicitly set out in the claims.

It is also noted herein that while the above describes example embodiments of the invention, these descriptions should not be viewed in a limiting sense. Rather, there are several variations and modifications which may be made without departing from the scope of the present invention as defined in the appended claims.

## Claims

1. An apparatus, comprising:
an element having at least one elongated member, said at least one elongated member having at least one conductive end and being extendable from a retracted position to at least one extended position;
a component coupled with said element, said component having at least one conductive surface at least partially opposing a side of said at least one conductive end when said at least one elongated member is in said at least one extended position; and
a dielectric disposed on at least one of said at least one conductive end and said at least one conductive surface.

2. An apparatus according to claim 1, wherein said at least one elongated member is a resilient member capable of at least one of extending and retracting said at least one conductive end substantially along an axis.

3. An apparatus according to any one of the preceding claims, wherein said at least one elongated member is capable of moving said at least one conductive end substantially along said axis when a force is exerted on said elongated member along another axis substantially perpendicular to said axis.

4. An apparatus according to any one of the preceding claims, wherein said at least one elongated member is capable of retracting along said axis when said force exerted on said elongated member is reduced.

5. An apparatus according to according to any one of the preceding claims, further comprising another component coupled with said apparatus, said another component having another at least one conductive surface at least partially opposing another side of said at least one conductive end when said at least one elongated member is in said at least one extended position.

6. An apparatus according to any one of the preceding claims, further comprising an actuator coupled with said apparatus, said actuator capable of being pressed by a user and transferring a force onto said at least one elongated member extending said at least one elongated member along an axis such that said side of said at least one conductive end at least partially opposes said at least one conductive surface and another side of said at least one conductive end at least partially opposes said another at least one conductive surface.

7. An apparatus according to claim 6, wherein said actuator having substantially at least one of a circular and polygonal shape, said actuator comprising a switching element located substantially at a center of said actuator.

8. An apparatus according to any one of the preceding claims, wherein a capacitance is capable of forming between one of said at least one conductive end and one of said another at least one conductive surface.

9. An apparatus according to any one of the preceding claims, further comprising an actuator coupled with said apparatus, said actuator capable of being pressed by a user and transferring a force onto said at least one of elongated member extending said at least one elongated member along an axis such that said side of said at least one conductive end at least partially opposes said at least one conductive surface.

10. A method, comprising:
applying a voltage between at least one conductive end of an element having at least one elongated member and at least one conductive surface of a component;
moving said at least one conductive end by extending said at least one elongated member from a retracted position to at least one extended position such that a side of said at least one conductive end at least partially opposes at least one conductive surface; and
measuring at least one capacitance level between said at least one conductive end and said at least one conductive surface.

11. A method according to claim 10, wherein said moving occurs in response to a user applying pressure at least indirectly to said at least one elongated member.

12. A method according to any one of claims 10-11, further comprising performing a function when at least one of said at least one capacitance level reaches at least one threshold level, said at least one capacitance level increases and said at least one capacitance level decreases.

13. A method according to claim 12, wherein said function comprises at least one of controlling a display, moving a cursor and entering data.

14. A method according to any one of claims 12-13, further comprising performing a function by actuating a switch coupled with said component.

15. An apparatus, comprising:
at least one processor; and
at least one memory comprising computer program code
said at least one memory and said computer program code configured to, with said at least one processor, cause the apparatus to perform at least the following:
apply a voltage between at least one conductive end of an element having at least one elongated member and at least one conductive surface of a component; and
detect a change in at least one capacitance level between said at least one conductive end and said at least one conductive surface in response to a movement of said at least one conductive end of said element between a retracted position and at least one extended position.
